Europäisches Patentamt

European Patent Office

Office européen des brevets

(11) Veröffentlichungsnummer: **0 404 230**

**A2**

## (12) EUROPÄISCHE PATENTANMELDUNG

(21) Anmeldenummer: **90201535.3**

(22) Anmeldetag: **14.06.90**

(51) Int. Cl.5: **H03L 7/183, H03L 7/093, H03B 5/36**

(30) Priorität: **20.06.89 DE 3920008**

(43) Veröffentlichungstag der Anmeldung:
**27.12.90 Patentblatt 90/52**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**

**Groenewoudseweg 1**
**NL-5621 BA Eindhoven(NL)**

(84) **FR GB**

(72) Erfinder: **Schemmel, Hans-Robert, Dipl.-Ing.**
**Friedrichstrasse 49**
**D-8500 Nürnberg 10(DE)**

(74) Vertreter: **Peuckert, Hermann, Dipl.-Ing. et al**
**Philips Patentverwaltung GmbH**
**Wendenstrasse 35 Postfach 10 51 49**
**D-2000 Hamburg 1(DE)**

(54) **Phasenregelkreis.**

(57)

2.1. Die Erfindung betrifft einen Phasenregelkreis mit einem Phasenvergleicher und einem über eine Schaltmatrix gesteuerten Oszillator. Die Frequenz des Oszillators soll auf einfache und preisgünstige Weise auch über die durch die Toleranzgrenzen der Schaltmatrix begrenzten Genauigkeitswerte hinaus präzise einstellbar sein.

2.2. Es wird vorgeschlagen, daß mindestens ein Schaltelement der Schaltmatrix von einem Pulslängenmodulator angesteuert wird.

2.3. Phasenregelkreise der Nachrichten- und Datentechnik.

EP 0 404 230 A2

Die Erfindung betrifft einen Phasenregelkreis mit einem Phasenvergleicher und einem über eine Schaltmatrix gesteuerten Oszillator.

Derartige Phasenregelkreise (PLL = phase locked loop) werden beispielsweise für Taktversorgungseinrichtungen in digitalen Dateneinrichtungen und Übertragungsnetzen benötigt. Der Phasenregelkreis besteht im wesentlichen aus einem spannungsgesteuerten Oszillator, einem Schleifenfilter und einem Phasenvergleicher, der die Phasenlage eines vom spannungsgesteuerten Oszillator erzeugten Signals mit der Phasenlage eines Eingangssignals vergleicht. Die vom Phasenvergleicher erzeugte Regelspannung steuert über das Schleifenfilter den Oszillator solange nach, bis die Phasendifferenz minimal ist, bzw. ein vor gegebener Sollwert erreicht wird.

Aus DE-A 33 24 919 ist ein Phasenregelkreis mit einem spannungsgesteuerten Oszillator bekannt, dessen Ausgang mit einem ersten Eingang eines Phasenvergleichers verbunden ist. An dem zweiten Eingang des Phasenvergleichers liegt ein Signal mit einer Referenzfrequenz an. Zwischen dem Phasenvergleicher und dem spannungsgesteuerten Oszillator liegt ein Zähler sowie eine Schaltelemente aufweisende Schaltmatrix, die beispielsweise als Kapazitätsmatrix ausgebildet ist und dann als Schaltelemente Kondensatoren verschiedener Kapazitätswerte aufweist. Die Frequenz des spannungsgesteuerten Oszillators ist über die Schaltmatrix durch das Parallelschalten der verschiedenen Kondensatoren in Stufen einstellbar. Die Einstellgenauig keit dieser Frequenz ist somit, insbesondere beim Ausfall der Referenzfrequenz, durch die Kapazitätstoleranzen der einzelnen Kondensatoren der Schaltmatrix begrenzt.

Der Erfindung liegt die Aufgabe zugrunde, einen Phasenregelkreis der eingangs genannten Art anzugeben, bei dem die Frequenz des spannungsgesteuerten Quarzoszillators auf einfache und preisgünstige Weise auch über die durch die Toleranz der Schaltmatrix begrenzten Genauigkeitswerte hinaus präzise einstellbar ist.

Diese Aufgabe wird bei einem Phasenregelkreis der eingangs genannten Art dadurch gelöst, daß mindestens ein Schaltelement der Schaltmatrix von einem Pulslängenmodulator angesteuert wird.

Vorteilhafte Ausgestaltungsformen sind in den Unteransprüchen enthalten.

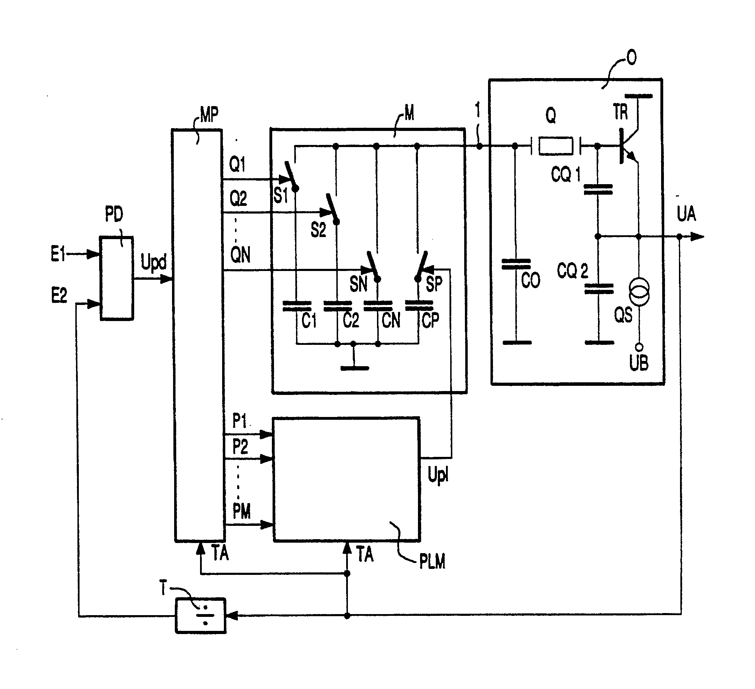

Im folgenden wird die Erfindung anhand eines in der Figur dargestellten Ausführungsbeispiels näher erläutert.

Die Figur zeigt ein Ausführungsbeispiel eines Phasenregelkreises.

Der in der Figur dargestellte Phasenregelkreis weist einen Phasenvergleicher PD auf, dem ein externes Signal E1 als Führungssignal und ein von einem spannungsgesteuerten Oszillator abgeleitetes Signal E2 als Vergleichssignal zugeführt werden. Das Signal E1 ist beispielsweise ein aus einem empfangenen Digitalsignal abgeleitetes Taktsignal. Der Phasenvergleicher PD vergleicht die Phasenlage der Frequenzen der Signale E1, E2 und liefert ein von der Phasenverschiebung abhängiges Signal Upd. Das Signal Upd wird einem Mikroprozessor MP zugeführt, der ein erstes Ausgangssignalbündel Q1...QN und ein zweites Ausgangssignalbündel P1...PM bildet. Der Mikroprozessor übernimmt insbesondere Filter- und Steueraufgaben und wird mit einem Takt TA eines von einem spannungsgesteuerten Oszillator O erzeugten Ausgangssignals UA getaktet. Das erste Ausgangssignalbündel Q1..QN des Mikroprozessors MP ist mit einer als Kapazitätsmatrix ausgebildeten Schaltmatrix M verbunden. Die Schaltmatrix M wird dabei aus einem aus Kondensatoren C1...CN, CP aufgebauten Kondensatornetzwerk gebildet, wobei ein Anschluß der Kondensatoren C1...CN, CP jeweils mit einem Bezugspotential (Masse) verbunden ist und der andere Anschluß jeweils über Schalter S1...SN, SP auf eine Klemme 1 schaltbar ist. Bei einer weiteren Ausführungsform ist die Schaltmatrix M als Induktivitätsmatrix ausgebildet. Die Schalter S1...SN der Schaltmatrix M werden jeweils von den Signalen Q1...QN gesteuert. Zwischen der Klemme 1 und dem Bezugspotential liegt somit eine Spannung an, die durch das Parallelschalten der Kondensatoren C1...CN, CP einstellbar ist. Die Klemme 1 ist mit dem spannungsgesteuerten Oszillator O verbunden. Im Oszillator O liegt zwischen der Klemme 1 und dem Bezugspotential ein Kondensator CO. Der erste Anschluß eines Schwingquarzes Q ist mit der Klemme 1, der zweite Anschluß mit der Basis eines Transistors T verbunden, dessen Kollektor auf Bezugspotential liegt. Parallel zur Basis-Emitter-Strecke des Transistors T liegt ein Kondensator CQ1 und zwischen dem Emitter und dem Bezugspotential ein Kondensator CQ2. Der Emitter des Transistors T ist über eine Stromquelle QS an eine Versorgungsspannung UB angeschlossen. Das am Emitter des Transistors T auftretende Signal UA mit einer Taktfrequenz TA wird einem Taktteiler T zugeführt, der daraus das dem Phasenvergleicher PD zugeführte Signal E2 bildet. Bei einer weiteren Ausführungsform ist zwischen die Klemme 1 der Schaltmatrix M und dem Schwingquarz Q ein Transformator und/oder eine Reaktanz zwischengeschaltet. Damit wird die Reaktanz der Schaltmatrix M an den Oszillator O angepaßt.

Das zweite Ausgangssignalbündel P1..PM des Mikroprozessors MP wird einem mit dem Takt TA getakteten Pulslängenmodulator PLM zugeführt, der daraus ein Signal Upl bildet. Das Signal Upl steuert den Schalter SP, durch den der an Masse liegende Kondensator CP den Kondensatoren C1...CN der Schaltmatrix parallel schaltbar ist. Der Pulslängenmodulator PLM wird bei dem in der Figur dargestellten Ausführungsbeispiel ebenfalls mit dem Takt TA getaktet. In einer bevorzugten Ausführungsform handelt es sich bei dem vom Pulslängenmodulator PLM angesteuerten Kondensator CP um das geringstwertige Schaltelement der Schaltmatrix M.

Bei einem praktisch ausgeführten Phasenregelkreis liefert der Phasenvergleicher PD aus dem Führungssignal E1 und dem Vergleichssignal E2 mit einer Frequenz von 16 kHz das Signal Upd mit einer Wortlänge von 8 Bit. Der Mikroprozessor MP vollzieht das Verhalten eines Schleifenfilters nach und wird bei dem praktisch ausgeführten Phasenregelkreis mit 6,144 MHz getaktet. Das erste Ausgangssignalbündel Q1...QN (5 Bit) steuert die Schalter S1...SN der Schaltmatrix M, die bei dem praktisch ausgeführten Phasenregelkreis als Kapazitätsmatrix ausgebildet ist. Durch die auf die Klemme 1 am Eingang des spannungsgesteuerten Oszillators O einander parallel schaltbaren Kondensatoren C1...CN, CP wird die an der Klemme 1 und Masse anliegende Spannung als Steuerspannung des spannungsgesteuerten Oszillators O gebildet und somit die Frequenz des Oszillators stufenweise einstellbar. Die Gesamtkapazität der Schaltmatrix ergibt sich dabei im wesentlichen aus der Summe der Kapazitäten der parallel geschalteten Kon densatoren C1...CN. Da die Kapazitätswerte der Kondensatoren C1...CN bestimmte Toleranzen von beispielsweise 1% aufweisen, ist die Genauigkeit der Frequenz der an der Klemme 1 und Masse anliegenden Spannung begrenzt. Diese Ungenauigkeit wird durch das zweite Ausgangssignalbündel P1...PM des Mikroprozessors M beseitigt. Dazu wird das zweite Ausgangssignalbündel P1...PM (8 Bit) dem Pulslängenmodulator PLM zugeführt, der ebenfalls mit dem Takt TA von 6,144 MHz getaktet wird. Das Ausgangssignal Upl des Pulslängenmodulators PLM steuert den Schalter SP und schaltet somit den Kondensator CP im Takt von 24 kHz den Kondensatoren C1...CN parallel. Der durch die Pulslängenmodulation erhaltene Kapazitätswert am Schalter SP entspricht dem Produkt aus dem Tastverhältnis des Pulslängenmodulators und dem Kapazitätswert des Kondensators CP. Die aus der Schaltmatrix M und dem Pulslängenmodulator PLM gebildete Gesamtkapazität ergibt sich somit aus der Summe der Gesamtkapazität der Schaltmatrix M und dem Produkt des Tastverhältnisses des Pulslängenmodulators und der Kapazität des Kondensators CP. Somit wird durch das Parallelschalten des von Pulslängenmodulator PLM angesteuerten Kondensators CP die Spannung an der Klemme 1 und Masse auch über die durch die Toleranzen der Kondensatoren C1...CN der Schaltmatrix M begrenzte Genauigkeit und damit die Frequenz des spannungsgesteuerten Oszillators präzise einstellbar. Bei dem praktisch ausgeführten Phasenregelkreis ergibt sich am Ausgang des Quarzoszillators O das Ausgangssignal UA mit der Taktfrequenz TA von 6,144 MHz, die den Mikroprozessor MP und den Pulslängenmodulator PLM taktet. Das Signal UA wird über einen Taktteiler T, der beim praktisch ausgeführten Phasenregelkreis eine Frequenzteilung mit dem Faktor 384 ausführt, als Vergleichssignal E2 dem Phasenvergleicher PD zugeführt.

**Ansprüche**

1. Phasenregelkreis mit einem Phasenvergleicher und einem über eine Schaltmatrix gesteuerten Oszillator,
dadurch gekennzeichnet,
daß mindestens ein Schaltelement (CP) der Schaltmatrix (M) von einem Pulslängenmodulator (PLM) angesteuert wird.

2. Phasenregelkreis nach Anspruch 1,
dadurch gekennzeichnet,
daß ein von einem Mikroprozessor gebildetes erstes Ausgangssignalbündel (Q1...QN) Schaltelemente (C1...CN) der Schaltmatrix (M) und mindestens ein weiteres Ausgangssignalbündel (P1...PM) dem Pulslängenmodulator (PLM) zugeführt wird, der insbesondere das geringstwertige Schaltelement (CP) ansteuert.

3. Phasenregelkreis nach einem der Ansprüche 1 oder 2,
dadurch gekennzeichnet,
daß der Pulslängenmodulator (PLM) mit einem von einem Ausgangssignal (UA) des spannungsgesteuerten Oszillators (O) abgeleiteten Takt (TA) getaktet wird.

4.. Phasenregelkreis nach einem der Ansprüche 1 bis 3,
dadurch gekennzeichnet,
daß die Schaltmatrix (M) als Kapazitäts- oder als Induktivitätsmatrix ausgebildet ist.

5. Phasenregelkreis nach einem der Ansprüche 1 bis 4,
dadurch gekennzeichnet,
daß zur Ansteuerung des Schaltelements (CP) ein Schalter (SP) vorgesehen ist, der durch den Takt (TA) gesteuert wird.

6. Phasenregelkreis nach einem der Ansprüche 1 bis 5,
dadurch gekennzeichnet,
daß der Phasenvergleicher (PD) mit Eingangssignalen (E1, E2) ein Ausgangssignal (UPD) liefert, das dem Mikroprozessor (MP) zugeführt wird.

7. Phasenregelkreis nach einem der Ansprüche 1 bis 6,
dadurch gekennzeichnet,
daß der Mikroprozessor (MP) und der Pulslängenmodulator (PLM) einen gemeinsamen Takt (TA) aufweisen.

8. Phasenregelkreis nach einem der Ansprüche 1 bis 7,
dadurch gekennzeichnet,
daß das Ausgangssignal (UA) über einen Taktteiler (T) dem Phasenvergleicher (PD) zugeführt wird.

9. Phasenregelkreis nach einem der Ansprüche 1 bis 8,
dadurch gekennzeichnet,
daß zwischen Schaltmatrix (M) und spannungsgesteuertem Oszillator (O) ein Transformator und/oder eine Reaktanz geschaltet sind.